# EUROPEAN PATENT APPLICATION

(11) **EP 4 844 945 A1**
(43) Date of publication of application: **25.11.2026**
(21) Application number: 26179826.8
(22) Date of filing: 20.05.2026
(51) Int. Cl.: H01Q 1/22, H01P 3/06, H01P 5/02, H01P 5/08, H01Q 1/52, H10W 44/20

(54) **SYSTEM IN PACKAGE MODULE INCLUDING COAXIAL CONNECTIONS**

(30) Priority: 21.05.2025 US 202519214274
(71) Applicant: NXP B.V., 5656 AG Eindhoven (NL)
(72) Inventor: Mandamparambil, Rajesh, 5656AG Eindhoven (NL); Acar, Mustafa, 5656AG Eindhoven (NL); Mattheijssen, Paul, 5656AG Eindhoven (NL); Bergman, Jan Willem, 5656AG Eindhoven (NL)
(74) Representative: Colaiuda, Antonella

(57) **Abstract**

A device may include a substrate including one or more layers of package routing and a coaxial wire trace. The coaxial wire trace includes a signal line and a shield wall. The signal line may include one or more vias extending through the one or more layers of the package routing and may include at least one first portion extending perpendicular to a surface of the substrate and optionally at least one second portion extending along a selected layer of the one or more layers between vertical portions. The shield wall may be coupled to a package ground to define a ground plane and may extend continuously around the signal line through the one or more layers to form a true coaxial connection between the substrate and a circuit die, between circuit dies, or between a circuit die and an antenna element.

## Description

### FIELD OF USE

The present disclosure generally relates to integrated circuits, and more particularly to system in package modules including multiple integrated circuits within a single package including printed circuit board (PCB)-to-die, die-to-die, or die-to-antenna coaxial connections.

### BACKGROUND

For high density Antenna-in-Package (AiP) modules operating at high frequencies, it is important to have good isolation between different conductive traces that carry radio frequency (RF) signals to avoid mutual interference and ultimately degradation of the antenna performance. Also, the routing of the signal from the PCB to the antenna and back may present challenges in ensuring proper signal-timing and limiting RF-losses.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1 depicts a diagram of an antenna-in-package (AiP) device including true coaxial connections between the PCB substrate and one or more dies (PCB-to-die), between dies (die-to-die), and between one or more dies and one or more antennas (die-to-antenna), in accordance with certain embodiments.
FIG. 2 depicts a diagram of a portion of the AiP device of FIG. 1 including die-to-die coaxial connections having equal connection lengths, in accordance with certain embodiments.
FIG. 3A depicts a diagram of a portion of the AiP device of FIG. 1 including a PCB-to-die coaxial connection, in accordance with certain embodiments.
FIG. 3B depicts a diagram of a portion of the AiP device of FIG. 1 including a portion of a die-to-die coaxial connection, in accordance with certain embodiments.
FIG. 4 depicts a diagram of a portion of the AiP device of FIG. 1 including a portion of a die-to-antenna coaxial connection, in accordance with certain embodiments.
FIG. 5 depicts a diagram of a portion of the AiP device of FIG. 1 including a portion of a perimeter shielding wall, in accordance with certain embodiments.
FIG. 6 depicts a flow diagram of a method of producing the AiP device of FIG. 1, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

Embodiments of an antenna-in-package (AiP) device are described below that may include a substrate and a plurality of dies coupled to the substrate including at least one die coupled to the substrate by a first coaxial connection. The AiP device may include a second coaxial connection configured to couple a first die to a second die. The AiP device may include an antenna, which may be coupled to a die of the plurality of dies by a third coaxial connection. In one or more embodiments, each of the first coaxial connection, the second coaxial connection, and the third coaxial connection may include a signal trace that may be electrically isolated along its length by one or more of a conductive walls (shield walls) coupled to a reference voltage, such as a package ground connection or another reference voltage. In one or more embodiments, the coaxial connections may provide up to 55 decibels (dB) of isolation between signal traces.

In one or more embodiments, the AiP device may include multiple stacked dies and molded layers. The AiP device may be formed using multi-layer fan-out wafer-level packaging (FOWLP) with antenna patches over the silicon area. The AiP device may include die-to-die coaxial routing including same-length RF traces through redistribution layer routing considerations and by rotated orientation of two of the dies to prevent transmission line timing differences between channels. The AiP device may include full coaxial PCB-to-die and die-to-die traces (such as digital up-down converter (UDC) circuit to analog beamforming (ABF) circuit coaxial connections) ensuring low-loss and signal isolation for radio frequency (RF) outputs. The AiP device may include full coaxial and straight die-to-antenna traces using high aspect-ratio features to achieve a small coaxial diameter fit within antenna-pitch and die-size limitations and to achieve package-perimeter and antenna-cavity shielding to reduce grating-lobes. The AiP device may include digital routing via the silicon to prevent crossing of digital and RF signal traces without increasing the layer count in the AiP device.

In one or more embodiments, an AiP device may be configured to operate at sub TeraHertz (THz) frequencies using RF-coaxial structures including electrically grounded perimeter walls and isolating straight walls extending through layers of the package from integrated circuit (IC) pads to antenna feed points to provide a selected antenna performance. For high density AiP devices operating at high frequency, it is important to have good isolation between different traces that carry RF signals to avoid mutual interference and ultimately degradation of the antenna performance. Also, the routing of the signal from the PCB substrate to the antenna and from the antenna to the PCB substrate presents a challenge with respect to proper signal-timing and limited RF losses.

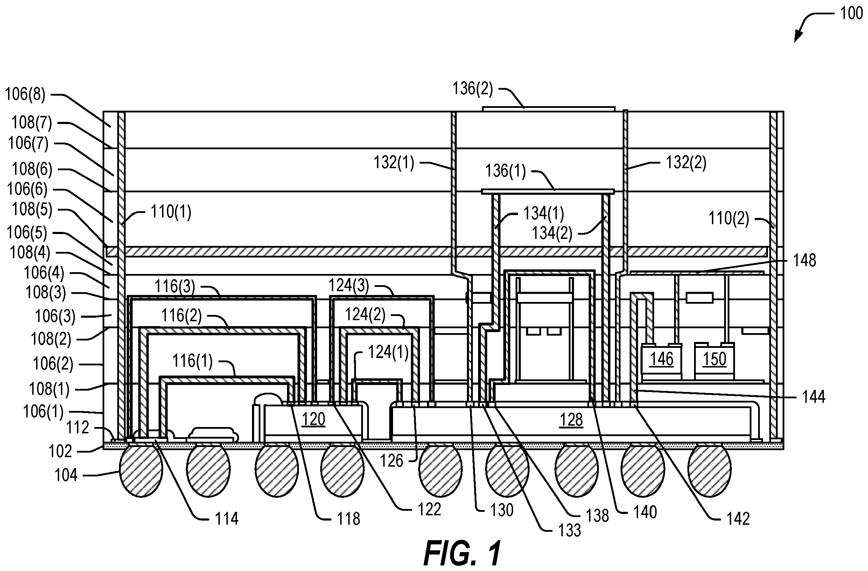

In one or more embodiments, an AiP device may include true coaxial connections between the PCB substrate and one or more dies, between dies, between dies and antenna elements, or any combination thereof. The AiP device may be suitable for surface mount technologies (SMT) and for a ball grid array (BGA) footprint. Embodiments of an AiP device are described below that include true coaxial connections. As used herein, the terms "coaxial connection," "true coaxial connection", "true coaxial trace" or "coaxial trace" refers to a signal trace that is fully shielded, end-to-end, by one or more shielding walls that surround the signal trace to isolate the signal trace from RF signals carried by other signal lines or from signals from other AiP devices. An example of an AiP device with true coaxial connections is described below with respect to FIG. 1.

FIG. 1 depicts a diagram of an antenna-in-package (AiP) device 100 including true coaxial connections between the PCB substrate 102 and one or more dies 124 and 130 (PCB-to-die), between dies (die-to-die), and between one or more dies 130 and one or more antennas 134 (die-to-antenna), in accordance with certain embodiments. In the illustrated example, the PCB substrate 102 may be mechanically and electrically coupled to an underlying substrate (not shown) by solder bumps or ball grid array, such as a solder bump 104. The PCB substrate 102 may include multiple layers and may include patterned metal layers, dielectric layers, and vias (not shown) to selectively couple a portion of a first patterned metal layer to a portion of a second patterned metal layer.

The AiP device 100 may include multiple mold compound layers 106 stacked on top of one another and separated by patterned redistribution layers 108. The patterned redistribution layers 108 may include electrically conductive traces that may be surrounded on all sides by electrically grounded shielding walls to provide true coaxial connections from the PCB substrate 102 to a die 120, from a die 120 to another die 128, from a die 128 to an antenna element 136, or any combination thereof.

In the illustrated example, the AiP device 100 may include a perimeter shielding wall 110. The perimeter shielding wall 110 may be formed from electrically conductive metal that is coupled to a reference voltage, such as the package ground, through a contact pad 112 of the PCB substrate 102. The perimeter shielding wall 110 is depicted here as a wire trace extending from the contact pad 112 at the PCB substrate 102 to a top surface of the mold compound layer 106(8), providing electromagnetic shielding from electromagnetic signals. It should be appreciated that the shielding wall 110 may be formed on all sides of the AiP device 100.

The AiP device 100 may include a first coaxial traces 116 configured to electrically couple a contact pad, such as the contact pad 114, which may be coupled to one of the solder bumps 104. The first coaxial traces 116 may provide a true coaxial connection between contact pads (such as the contact pad 114) of the PCB substrate 102 and one or more circuit dies, such as the circuit die 120. In the illustrated example, the first coaxial traces 116 are depicted as solid metal traces; however, each of the first coaxial traces 116 may include a conductive signal trace that is separated from and surrounded by electrically conductive walls that are coupled to a reference voltage, such as the package ground. The signal trace and the electrically conductive walls may extend along the full length of the first coaxial traces 116, for example, providing a shielded connection between the contact pad 114 and a contact pad 118 of the circuit die 120.

In the following discussion, the terms "vertical" and "horizontal" are used to describe portions of the coaxial traces. Such terms are used herein to describe the particular depiction of an embodiment in FIG. 1 and are not intended to be limiting. In general, the terms are used in order to explain that the shielded coaxial connection is maintained even as the electrical connection changes direction and extends through the molded layers 106 and the patterned redistribution layers 108.

In the illustrated example, a coaxial trace 116(1) includes a first vertical portion extending from the contact pad on the PCB substrate 102 through the first molded compound layer 106(1) to a first patterned redistribution layer 108(1), a horizontal portion that extends along the first patterned redistribution layer 108(1), and a second vertical portion extending from the first patterned redistribution layer 108(1) to the contact pad 118 of the circuit die 120. A coaxial trace 116(2) includes a first vertical portion extending from a contact pad on the PCB substrate 102 through the first molded compound layer 106(1) and a second molded layer 106(2) to a second patterned redistribution layer 108(2), a horizontal portion that extends along the second patterned redistribution layer 108(2), and a second vertical portion extending from the second patterned redistribution layer 108(2) to a contact pad of the circuit die 120. A coaxial trace 116(3) includes a first vertical portion extending from a contact pad on the PCB substrate 102 through the first molded compound layer 106(1), the second molded layer 106(2), and a third molded layer 106(3) to a third patterned redistribution layer 108(3). The coaxial trace 116(3) includes a horizontal portion that extends along the third patterned redistribution layer 108(3) from the first vertical portion to a second vertical portion, which extends from the third patterned redistribution layer 108(3) to a contact pad of the circuit die 120. Each of the first coaxial traces 116 is configured to provide a shielded coaxial connection between a contact pad of the PCB substrate 102 and the die 120.

The AiP device 100 may include second coaxial traces 124 configured to provide a shielded coaxial connection between the die 120 and a die 128. Each of the second coaxial traces 124 may include a conductive signal trace that is separated from and surrounded by electrically conductive walls that are coupled to a reference voltage, such as the package ground. The signal trace and the electrically conductive walls may extend along the full length of the first coaxial traces 124, for example, providing a shielded connection between the circuit die 120 and the circuit die 128. A coaxial trace 124(2) may include a vertical first portion extending from a contact pad 122 on the die 120 through the first mold compound layer 106(1) to the first redistribution distribution layer 108(1), a horizontal portion that extends along the first patterned redistribution layer 108(1), and a second vertical portion extending from the first patterned redistribution layer 108(1) to a contact pad 130 of the circuit die 128. A coaxial trace 124(2) includes a first vertical portion extending from a contact pad on the circuit die 120 through the first molded compound layer 106(1) and the second molded layer 106(2) to the second patterned redistribution layer 108(2), a horizontal portion that extends along the second patterned redistribution layer 108(2), and a second vertical portion extending from the second patterned redistribution layer 108(2) to a contact pad 126 of the circuit die 128. A coaxial trace 116(3) includes a first vertical portion extending from a contact pad on the circuit die 120 through the first molded compound layer 106(1), the second molded layer 106(2), and the third molded layer 106(3) to the third patterned redistribution layer 108(3). The coaxial trace 116(3) includes a horizontal portion that extends along the third patterned redistribution layer 108(3) from the first vertical portion to a second vertical portion, which extends from the third patterned redistribution layer 108(3) to a contact pad of the circuit die 128.

The AiP device 100 may include an antenna shielding wall formed by metal traces 132 that may surround an antenna cavity including wire traces 134 and antenna elements 136. In the illustrated example, the antenna shielding wall 132(1) may be coupled to a contact pad 130 of the circuit die 128 and the antenna shielding wall 132(2) may be coupled to a different contact pad of the circuit die 128. In other implementations, the antenna shielding wall formed by metal traces 132 may be coupled to a reference voltage, such as the package ground, through the circuit die 128 or by traces external to the circuit die 128.

The antenna element 136(1) may be coupled to the circuit die 128 by coaxial traces 134. The coaxial traces 134 may include a conductive signal trace that is separated from and surrounded by electrically conductive walls that are coupled to a reference voltage, such as ground. The signal trace and the electrically conductive walls may extend along the full length of the first coaxial traces 116, for example, providing a shielded connection between the contact pad 114 and a contact pad 118 of the circuit die 120. The coaxial trace 134(1) may include a first vertical portion extending from a contact pad 132 through the first mold compound layer 106(1) and the second mold compound layer 106(2) to the second patterned metallization layer 108(2). The coaxial trace 134 may include a horizontal portion extending along the second patterned metallization layer 108(2) and a second vertical portion extending from the second patterned metallization layer 108(2) to the antenna element 136(1) through the third, fourth, fifth, and sixth mold compound layers 106(3), 106(4), 106(5), and 106(6). In this example, the antenna element 136(1) may be formed at the sixth patterned metallization layer 108(6). The coaxial trace 134(2) may extend vertically between the antenna element 136(1) and a contact pad of the circuit die 128. In a transmission mode, the antenna element 136(1) may emit radio frequency signals that may excite the antenna element 136(2) to radiate electromagnetic signals. The mold compound layers 106(7) and 106(8) and the patterned metal layer 108(7), at least in the area between the antenna elements 136 may enable or otherwise facilitate radio frequency signals by having a selected permittivity to enable signal propagation through the mold compound layers and between the antenna shielding walls 132.

In one or more embodiments, the AiP device 100 may include a coaxial connection 140 between a first contact pad 133 and a second contact pad on the circuit die 128. The AiP device 100 may include non-coaxial connections, such as a wire trace 144 extending between a contact pad 142 on the circuit die 128 and a contact pad on a circuit element, such as a decoupling capacitor 146, which may be coupled to the first metallization layer 106(1). The decoupling capacitor 146 may be coupled to another circuit device 150 through a wire trace 148. The wire trace 148 may include a first portion extending vertically through the second, third, and fourth mold compound layers 106(2), 106(3), and 106(4) to the fourth patterned metallization layer 108(4); a second portion extending horizontally along the fourth patterned metallization layer 108(4); and a third portion extending vertically through the fourth, third, and second mold compound layers 106(4), 106(3), and 106(2) to a contact pad on the circuit device 150. In one or more embodiments, the wire trace 144 may be coupled to a decoupling capacitor or other circuit component configured to provide power supply decoupling.

In the illustrated example, the circuit die 120 may be an up-down converter circuit. The circuit die 128 may be a beamformer integrated circuit. In one or more embodiments, the decoupling capacitor 146 and the circuit device 150 may be replaced with any type of circuit element or integrated circuit device.

In one or more embodiments, the AiP device 100 may include one or more analog beamformer circuits, such as the circuit device 128, to steer the antenna elements 136 (i.e., antenna patches) and may include the circuit die 120 (i.e., Up-Down Converter circuit) to transform between intermediate frequence (IF) and radio frequency (RF) frequencies. Several identical analog beamformer circuits (i.e., circuit devices 128) may be controlled such that each steers multiple antenna elements 136 to achieve a desired number of antenna-patches on the AiP device 100. The orientation of the circuit dies 128 on the PCB substrate 102 may be controlled to allow for equal length die-to-die connection traces (i.e., coaxial traces 124) to assure equal timing to each circuit die 128. To prevent congestion and crossing of digital signals with the coaxial traces 124, part of the coaxial trace 124 may be routed through the circuit die 128 using a die-to-die coaxial trace 124 to a next circuit die 128.

In one or more embodiments, the AiP device 100 may be formed using a die-first face-up Fan-Out Wafer Level Package (FOWLP) process with multiple layers, using a technique that enables high aspect ratio vertical walls to connect between the horizontal redistribution layers (RDLs) 106. In one or more embodiments, the radio frequency traces can be shielded on top, bottom and at the sides, creating true coaxial connections 116 between the PCB substrate 102 and the circuit die 120, true coaxial connections 124 from die-to-die (e.g., from circuit die 120 to circuit die 128), and true coaxial connections 134 from die-to-antenna (e.g., from circuit die 128 to antenna element 136), while keeping minimal XY dimensions (allowing higher density features than in conventional packages).

In one or more embodiments, the circuit die 128 may be arranged such that the antenna elements 136 are directly above the circuit die 128, which allows straight, minimal and equal length coaxial traces 134 from die-to-antenna. The vertical shielding wall 110 may be provided on the perimeter of the AiP device 100 and the vertical shielding wall 132 may be provided to form antenna-cavities. Both shielding walls 110 and 132 may be provided to create electromagnetic isolation between neighboring AiP devices 100 and between neighboring antennas, respectively.

In one or more embodiments, the mold compound layers 106 may vary in thickness and in material properties, if needed. The composition of any mold compound layer 106 may be selected to improve radio frequency isolation, digital isolation, antenna isolation, or any combination thereof. In one or more embodiments, thicker mold compound layers 106 may allow embedding of integrated circuit devices, supply decoupling capacitors (such as the capacitor 146), or other integrated active or passive circuit devices. In one or more embodiments, a bottom side redistribution layer may be added to the PCB substrate 102 to connect to solder-bumps 104 for signal or thermal pathways and to allow surface mount technology (SMT) on the PCB substrate 102. In one or more embodiments, the AiP device 100 may be enabled by using three-dimensional (3D) redistribution layer technology and design rules.

In one or more embodiments, the AiP device 100 may be designed to provide antenna signals at frequency ranges greater than 50 GHz. In one or more embodiments, the AiP device 100 may support antennas that operate in the 100 GHz range. In one or more embodiments, the AiP device 100 may be configured to operate at a 100 GHz range with approximately 60 dB of isolation between signal lines and between AiP devices 100 of a circuit that includes multiple AiP devices 100.

It should be understood that the illustrated example of FIG. 1 is not necessarily drawn to scale but is provided for illustrative purposes. Further, it should be understood that the thicknesses of the mold compound layers 106 may vary. Additionally, the composition of the mold compound layers 106 may vary from layer to layer or within a selected mold compound layer 106. The thickness and the composition of a selected mold compound layer 106 may be selected to provide a desired radio frequency characteristic, a desired electrical characteristic, for other considerations, or any combination thereof.

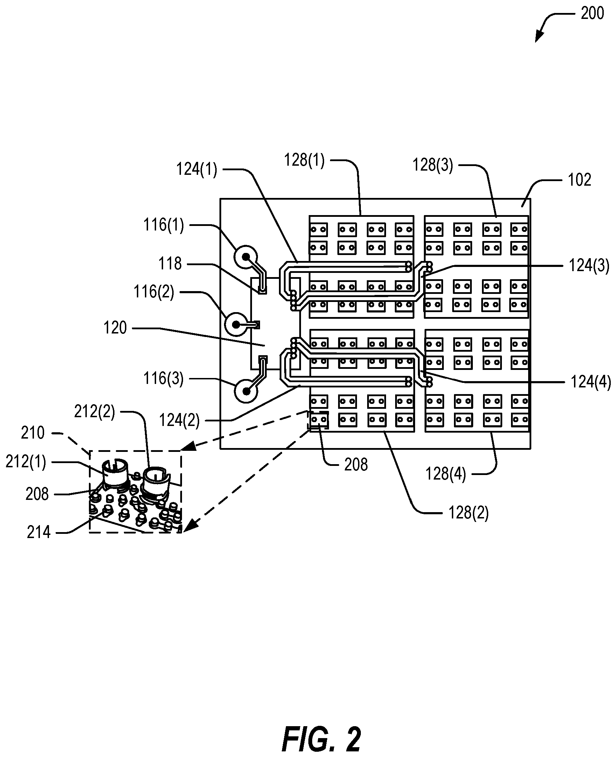

As mentioned above, identical circuit dies 128 may be selected and oriented on the PCB substrate 102. The selected orientations and the configurations of the coaxial wire traces 124 are the same length so that timing differences between channels are minimized. An example of a circuit layout for the AiP device 100 is described below with respect to FIG. 2.

FIG. 2 depicts a diagram of a portion 200 of the AiP device 100 of FIG. 1 including die-to-die coaxial connections (second coaxial traces 124) having equal connection lengths, in accordance with certain embodiments. The portion 200 of the AiP device 100 includes a portion of the PCB substrate 102 with the circuit die 120 and multiple circuit dies 128 attached thereto. In one or more embodiments, the circuit die 120 may include an Up-Down Converter circuit, and the circuit dies 128 may include analog beamformer integrated circuits configured to couple to the antenna element 136(1).

In one or more embodiments, the circuit die 120 may be coupled to the PCB substrate 102 by coaxial wire traces 116. In the illustrated example, the coaxial wire trace 116(1) may carry an intermediate-frequency receive signal (IF-RX) to the contact pad 118 of the circuit die 120. The coaxial wire trace 116(2) may carry a local oscillator signal (LO) to a contact pad of the circuit die 120. The coaxial wire trace 116(3) may carry an intermediate-frequency transmit signal (IF_TX) to a contact pad of the circuit die 120. In the illustrated example, the rounded portion of the wire traces 116 may represent the horizontal portion depicted in FIG. 1

In one or more embodiments, the circuit die 120 may be coupled to the circuit die 128 by equal-length coaxial wire traces 124. The coaxial wire trace 124(1) may couple the circuit device 120 to the circuit device 128(1). The coaxial wire trace 124(2) may couple the circuit device 120 to the circuit device 128(2). The coaxial wire trace 124(3) may couple the circuit device 120 to the circuit device 128(3). The coaxial wire trace 124(4) may couple the circuit device 120 to the circuit device 128(4). While the two-dimensional illustrated example shows coaxial wire traces 124 that may seem to be different lengths, the relative lengths may be equalized by extending vertically to different elevations within the mold compound layers 106 (in FIG. 1).

In the illustrated example, the AiP device 100 includes four analog beamformer dies (circuit dies 128) to steer the antenna patches (136 in FIG. 1) and an Up-Down Converter (circuit die 120) to transform between IF and RF frequencies. Each analog beamformer die (circuit die 128) may be used to steer multiple antenna patches 136 to control the desired number of antenna-patches on the AiP device 100. The orientation of the analog beamformer dies (circuit dies 128) is such that the contract pads of a first circuit die 128(1) are adjacent to the contact pads of a third circuit die 128(3), and the contact pads of a second circuit die 128(2) are adjacent to the contact pads of a fourth circuit die 128(4). The selected orientation facilitates the formation of equal length die-to-die connection traces (coaxial traces 124), to assure equal timing to each circuit die 128.

In one or more embodiments, to prevent congestion and crossing of digital signals with the coaxial traces 124, part of the coaxial trace 124 can be routed through the circuit die 128 and through a die-to-die coaxial trace 124 to the next circuit die 128. In one or more embodiments, digital routing through the circuit die 128 may allow a digital feed from north and south sides of the AiP device 100 to avoid obstructing the die-to-die coaxial traces 124. Alternatively, such digital routing may be provided through additional die-to-die coaxial traces 124 at different elevations within the mold compound layers 106.

In the illustrated example, the circuit devices 128 may include a plurality of circuit modules 208, each of which may include coaxial interconnections for connecting to an antenna element 136. An expanded view of the circuit module 208 is shown at 210. In this view, a portion of a substrate 208 of the circuit module 208 may support a plurality of circuit elements 214 and a portion of a vertical coaxial connections 212 to couple the circuit device 128 to an antenna element 136.

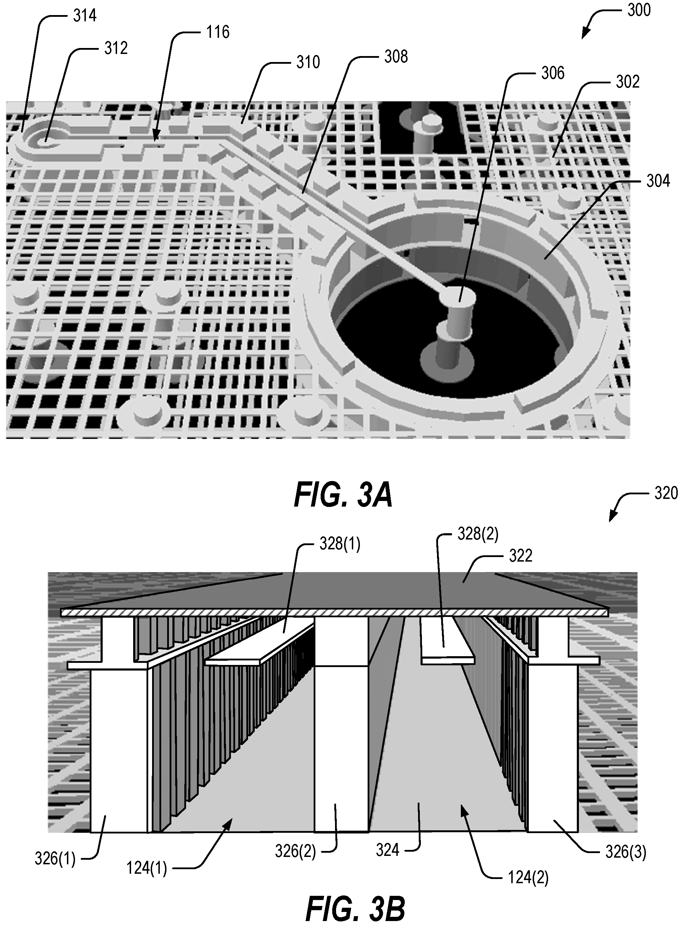

FIG. 3A depicts a diagram of a portion 300 of the AiP device 100 of FIG. 1 including a PCB-to-die coaxial connection 116, in accordance with certain embodiments. In the illustrated example, the portion 300 may include a ground plane 302 including a vertical shield wall 304 to provide electromagnetic isolation for the vertical portion of the coaxial wire trace 116. The vertical shield wall 304 surrounds the vertical signal trace 306, which is coupled to a horizontal signal trace 308 that is surrounded by a shield wall 310. The second vertical signal trace 312 of the coaxial wire trace 116 is also surrounded by a vertical shield wall 314.

In the illustrated example of FIG. 3A, the top portion of the shielding of the coaxial wire trace 116 is omitted. However, it should be understood that the entire length of the coaxial wire trace 116 includes grounded shielding walls to isolate the signal trace306, 308, and 312 from external electromagnetic signals.

FIG. 3B depicts a diagram of a portion 320 of the AiP device 100 of FIG. 1 including a portion of a die-to-die coaxial connection 124, in accordance with certain embodiments. In the illustrated example, the portion 320 may include coaxial traces 124(1) and 124(2), which may be isolated by grounded walls, such as top wall 322, bottom wall 324, and sidewalls 326. Electrically conductive signal traces 328 may extend between the top wall 322, the bottom wall 324, and the sidewalls 326 to form coaxial traces 124. The same structure may form the horizontal signal trace 308 of the coaxial trace 116 as shown in FIG. 3A (which had the top wall 322 removed).

In the illustrated example, the walls 322, 324, and 326 may be coupled to one another and to a reference voltage, such as the package ground. The walls 322, 324, and 326 may be formed from electrically conductive material that is maintained at a potential of the reference voltage (or package ground), thereby insulating the signal traces 328 from RF signals carried by nearby signal traces or from other AiP devices 100.

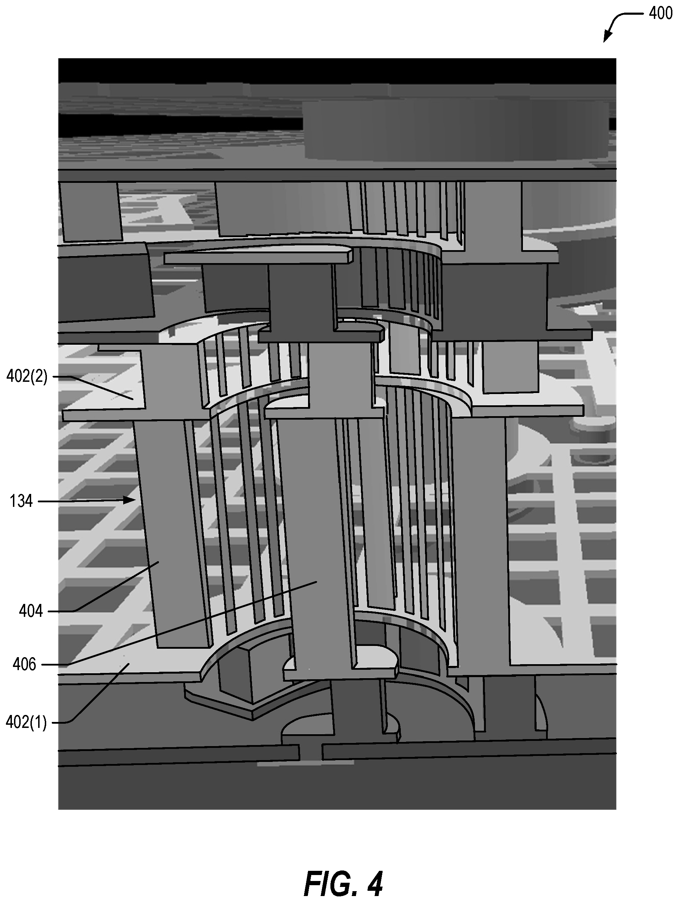

FIG. 4 depicts a diagram 400 of a portion of the AiP device 100 of FIG. 1 including a portion of a die-to-antenna coaxial connection, in accordance with certain embodiments. In the illustrated example, the coaxial connection 134 is shown extending vertically through multiple layers. The coaxial connection 134 includes sidewalls 404 surrounding an opening that extends through ground layers 402. The sidewalls 404, in this illustrative, non-limiting example, are formed from pillars of conductive metal, which may be coupled to a reference voltage, such as the package ground. The coaxial connection 134 may include a conductive trace 406 extending between and separated from the sidewalls 404 to carry the analog radio frequency signal. The sidewalls 404 and the ground planes 402 may operate to shield the conductive signal trace 406 from radio frequency interference.

Though the coaxial connection 134 is depicted, the antenna element 136 to which it is connected is not shown in this embodiment. Further, it should be understood that the vertical portions of the conductive signal traces 406, 306 and 312 of the coaxial connections 116 and 124 may have a similar structure.

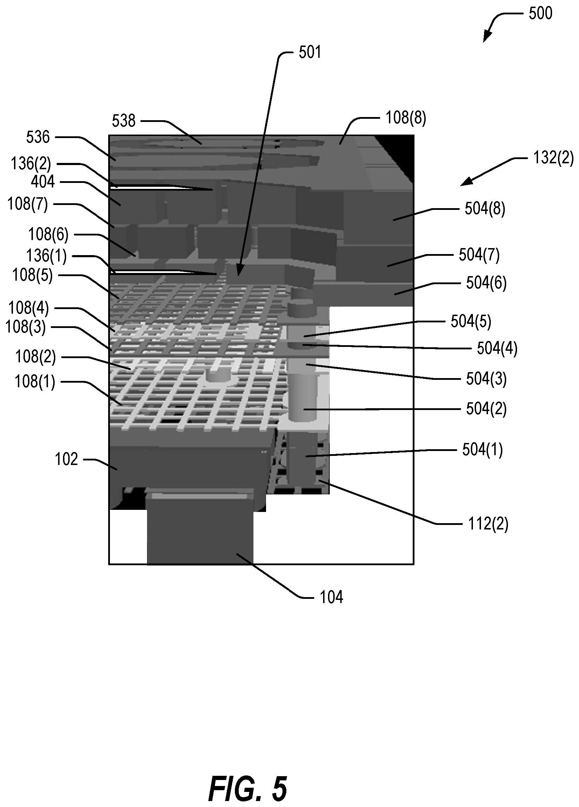

FIG. 5 depicts a diagram of a portion 500 of the AiP device 100 of FIG. 1 including a portion of a perimeter shielding wall 504, in accordance with certain embodiments. In the illustrated example, the portion 500 may include a buildup of mold compound layers 106 and metallization layers 108 on the PCB substrate 102 and may include an antenna cavity 501, which may be formed around the antenna elements 136(1) and 136(2).

In this example, the PCB substrate 102 may be coupled to a solder bump 104. Additionally, the PCB substrate 102 may include a contact pad or metallization layer 502 that may be coupled to a reference voltage, such as a package ground. The build-up may include metallization layers 108, which may be separated by mold compound layers 106 (not shown here).

In this example, the shielding wall 132(2) may include a first portion 504(1) extending between the contact pad 112(2) of the substrate 102 and a first metallization layer 108(1). The shielding wall 132(2) may include a second portion 504(2) extending between the first metallization layer 108(1) and a second metallization layer 108(2). A third portion 504(3) may extend between the second metallization layer 108(2) and a third metallization layer 108(3). A fourth portion 504(4) may extend between the third metallization layer 108(3) and a fourth metallization layer 108(4). A fifth portion 504(5) may extend between the fourth metallization layer 108(4) and a fifth metallization layer 108(5). A sixth portion 504(6) may extend between the fifth metallization layer 108(5) and a sixth metallization layer 108(6). A seventh portion 504(7) may extend between the sixth metallization layer 108(6) and a seventh metallization layer 108(7). An eighth portion 504(8) may extend between the seventh metallization layer 108(7) and an eighth metallization layer 108(8). The antenna 136(2) may be seen formed on or as part of the eighth metallization layer 108(8), which is patterned.

In one or more embodiments, the metallization layers 108 and the shielding wall 132 (portions 504) may provide electromagnetic shielding from RF signals. It should be appreciated that, in the illustrated example, portions of the antenna element 136(1) and the antenna element 136(2) are shown. The coaxial traces 134(1) and 134(2) to the antenna element 136(1) are omitted. The sidewalls 404 (see also FIG. 4) of the antenna cavity 501 are shown. In the portion 500, two other antenna elements 536 and 538 are also visible in the patterned metallization layer 108(8). The antenna elements 536 and 538 may be embodiments of the antenna element 136(2) and are adjacent antenna elements within an array. Each of the antenna elements 136, 536, and 538 may include a first antenna element (such as the antenna element 136) coupled to the circuit device 128 by a coaxial wire trace 134 including a coaxial signal trace (such as the coaxial signal trace 404 in FIG. 4) extending vertically within the antenna cavity 501. It should be understood that the AiP device 100 may include a selected number of antenna elements 136.

In one or more embodiments, the shielding wall 132 and the patterned metallization layers 108 around the coaxial trace 134 (not shown in FIG. 5) and the antenna elements 136(1) and 136(2) may creating isolation between neighboring AiP devices 100 or neighboring antennas 136, respectively. In one or more embodiments, the layers of the package stack (i.e., the molding compound layers 106 and the metallization layers 108) may vary in thickness, which variations may be inferred from the varied thicknesses of the metallization layers 108 and the spacing between the metallization layers 108 in FIG. 5. Further, in one or more embodiments, the material properties of the molding compound layers 106 may be varied to provide selected circuit characteristics, such as to improve RF-isolation, digital-isolation, antenna-isolation, or any combination thereof. In one or more embodiments, the thicker mold compound layers 108 may enable embedding of silicon integrated circuits, supply decoupling capacitors based on integrated passive devices, other circuit elements, other die, or any combination thereof.

In one or more embodiments, a bottom side redistribution layer (RDL) may be added to the PCB substrate 102 to connect to solder bumps 104 for signal or thermal pathways and to enable surface mount technology (SMT) on the PCB substrate. In one or more embodiments, the formation of true coaxial wire traces 116, 124, and 134 is enabled by three-dimensional (3D) redistribution layer (RDL) process technology and design rules. In one or more embodiments, perimeter shielding wall 110 may be conformal. Additionally, the perimeter shielding walls 132 may be conformal. Additionally, the walls 322, 324, and 326 around the signal traces 328 forming horizontal portions of the wire traces 116 and 124 may be straight and conformal to form true coaxial connection.

In one or more embodiments, the sidewalls 326 (FIG. 3) and 404 (FIG. 4) are depicted as pillars, which provide RF frequency isolation for the signal lines (e.g., traces 328 and 406). In one or more embodiments, the sidewalls 326 and 404 may be implemented as continuous walls. In one or more embodiments, the sidewalls 326 and 404 may operate to provide isolation between signal lines of 55 decibels (dB) or more.

Further, the true coaxial traces 116, 124, and 134 may enable good isolation and low loss for RF traces. The shielding wall 132 for the antenna cavity 501 may enable good isolation between antenna elements 136 and between AiP devices 100. In one or more embodiments, the antenna elements 136 are integrated in the buildup layers above the circuit die 128, enabling supply decoupling capacitors distributed evenly over the various channels of the AiP device 100. Straight and equal length coaxial traces 134 between IC-channels of the circuit die 128 and antenna elements 136 eliminate phase-shift and timing difficulties for beam-steering by the analog beam former circuit. In one or more embodiments, the AiP device 100 may be applied in high frequency millimeter waveform (mmW) antenna applications, where one or multiple integrated circuits and one or multiple antennas are using a stacked fan-out wafer-level packaging (FOWLP) process to create equal length coaxial shielding for RF-traces and vertical shielding for the antenna cavity 501 and the AiP device 100.

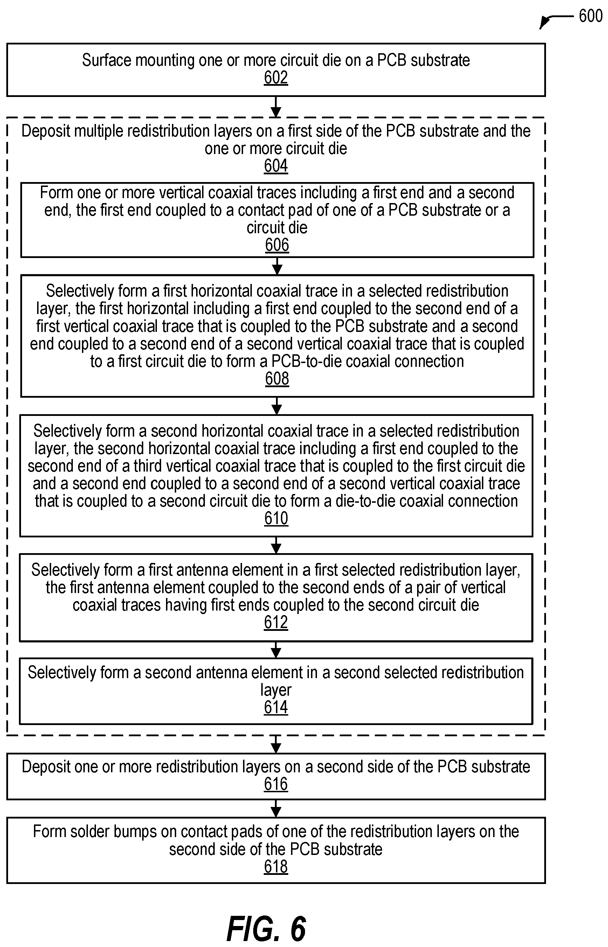

FIG. 6 depicts a flow diagram of a method 600 of producing the AiP device of FIG. 1, in accordance with certain embodiments. It should be appreciated that the method 600 is provided for illustrative purposes only and is not intended to be limiting. In one or more embodiments, the method 600 may be performed using a 3D RDL process technology or other process methodologies.

At 602, the method 600 may include surface mounting one or more circuit die 120, 128 onto a PCB substrate 102. The circuit die 120, 128 may be coupled to contact pads or otherwise attached to the PCB substrate 102.

At 604, the method 600 may include depositing multiple redistribution layers on a first side of the PCB substrate 102 and the one or more circuit die 120,128. In one or more embodiments, the multiple redistribution layers may be formed as metallization layers 108 between mold compound (dielectric) layers 106. In one or more embodiments, conductive vias may be formed to couple a patterned portion of a selected redistribution layer to a circuit die or to the PCB substrate 102.

Depositing multiple redistribution layers, at 604, may include multiple steps that are performed in conjunction with one another or concurrently. In one or more embodiments, at 604, the method 600 may include forming one or more vertical coaxial traces including a first end and a second end, the first end coupled to a contact pad of one of a PCB substrate or a circuit die, at 606. Each vertical coaxial trace may include shielding walls surrounding the conductive signal trace.

At 608, the method 600 may include selectively forming a first horizontal coaxial trace in a selected redistribution layer, the first horizontal including a first end coupled to the second end of a first vertical coaxial trace that is coupled to the PCB substrate and a second end coupled to a second end of a second vertical coaxial trace that is coupled to a first circuit die to form a PCB-to-die coaxial connection. In one or more embodiments, the vertical coaxial traces and the horizontal coaxial trace may form a true coaxial trace 116 between the PCB substrate 102 and a circuit die 120. In one or more embodiments, the horizontal coaxial trace may include walls 322, 324, and 326 surrounding a conductive radio frequency trace 328.

At 610, the method 600 may include selectively forming a second horizontal coaxial trace in a selected redistribution layer, the second horizontal coaxial trace including a first end coupled to the second end of a third vertical coaxial trace that is coupled to the first circuit die and a second end coupled to a second end of a second vertical coaxial trace that is coupled to a second circuit die to form a die-to-die coaxial connection. In one or more embodiments, the vertical coaxial traces and the horizontal coaxial trace may form a true coaxial trace 124 between circuit dies, such as the circuit die 120 and the circuit die 128. In one or more embodiments, the horizontal coaxial trace may include walls 322, 324, and 326 surrounding a conductive radio frequency trace 328.

At 612, the method 600 may include selectively forming a first antenna element in a first selected redistribution layer, the first antenna element coupled to the second ends of a pair of vertical coaxial traces having first ends coupled to the second circuit die. In one or more embodiments, the first antenna element may correspond to antenna element 136(1). The coaxial wire traces 134 may be vertical coaxial traces that extend between the circuit die 128 and the antenna element 136(1).

At 614, the method 600 may include selectively forming a second antenna element in a second selected redistribution layer. In one or more embodiments, the method 600 may include one or more additional redistribution layers between the antenna element 136(1) and a second antenna element 136(2), which may be arranged directly above the antenna element 136(1).

At 616, the method 600 may include depositing one or more redistribution layers on a second side of the PCB substrate 102. At 618, the method 600 may include forming solder bumps 104 on contact pads of one of the redistribution layers on the second side of the PCB substrate 102.

It should be appreciated that the method 600 is a simplified, non-limiting example of a method of producing the AiP device 100. The steps identified in the method 600 may be performed in a different order or concurrently. Some steps may be omitted or may be combined. In one or more embodiments, one or more of the steps may include multiple steps or operations to perform the steps. In general, the process may produce an AiP device 100 that includes true coaxial traces configured to form connections including a PCB-to-die connection, a die-to-die connection, a die-to-antenna connection, or any combination thereof.

In conjunction with the multi-layer circuits and methods of FIGs. 1-6, the circuit may include one or more coaxial traces configured to carry RF signals. The coaxial traces may be shielded on top, bottom, and along the sides to create true coaxial connections for conductive traces to enable PCB-to-die, die-to-die, and die-to-antenna connections. The true coaxial connections may be formed while keeping minimal X-Y dimensions, allowing for higher density features than in conventional packages.

In one or more embodiments, the arrangement of dies and antenna is made such that the antenna patches are directly above the silicon, allowing straight, minimum and equal length true coaxial traces from die-to antenna. A first vertical shielding wall may be provided along a perimeter of the package, and each antenna cavity may have a conformal shielding wall surrounding a conductive wire trace to provide a true coaxial connection from a circuit die 128 (such as an analog beam former circuit to the antenna element 136).

In one or more embodiments, an AiP device 100 may include a plurality of coaxial wire traces. Each of the plurality of coaxial wire traces including one or more walls coupled to a reference voltage, such as a package ground and surrounding a conductive wire trace. The plurality of coaxial wire traces including at least one of a first coaxial wire trace to couple a PCB contact pad to a first circuit die, a second coaxial wire trace to couple the first circuit die to a second circuit die, and a third coaxial wire trace to couple the second circuit die to an antenna element.

In one or more embodiments, a circuit device may include a substrate including one or more layers of package routing and a coaxial wire trace. The coaxial wire trace includes a signal line and a shield wall. The signal line may include one or more vias extending through the one or more layers of the package routing and may include at least one first portion extending perpendicular to a surface of the substrate and optionally at least one second portion extending along a selected layer of the one or more layers between vertical portions. The shield wall may be coupled to a package ground to define a ground plane and may extend continuously around the signal line through the one or more layers to form a true coaxial connection between the substrate and a circuit die, between circuit dies, or between a circuit die and an antenna element.

Embodiments of the present disclosure may be further understood in view of the following examples. In the following examples, in one or more embodiments, the device may be an integrated circuit including multiple dies and a buildup of dielectric layers and patterned metallization layers. In one or more embodiments, the device may be a small, modular integrated circuit designed to perform one or more pre-determined functions, which device may sometimes referred to as a "chiplet."

Example 1: A device includes a substrate including one or more layers of package routing and a coaxial wire trace. The coaxial wire trace include a signal line including one or more vias extending through the one or more layers of the package routing, the signal line including at least one first portion extending perpendicular to a surface of the substrate; and a shield wall coupled to a package ground and defining a ground plane extending around the signal line and extending continuously around the signal line through the one or more layers and extending around the at least one first portion; and where the shield wall and the signal line form a true coaxial connection between a contact pad and one of a second contact pad and an antenna element.

Example 2: The device of Example 1, where one or more of a thickness or a composition of the one or more layers is different from others of the one or more layers.

Example 3: The device of any of Examples 1 or 2, where the shield wall includes at least one first shield wall portion that corresponds to the at least one first portion of the signal line.

Example 4: The device of Example 3, where the at least one first shield wall portion is conformal to the at least one first portion of the signal line.

Example 5: The device of any of the Examples 1-4, where the signal line includes at least one second portion extending parallel to the surface of the substrate at a selected layer within the one or more layers of the package routing; and the shield wall includes at least one second shield wall portion that corresponds to the at least one second portion of the signal line.

Example 6: The device of Example 5, where the shield wall includes conductive pillars configured to provide radio frequency isolation from adjacent signal lines and from external radio frequency signals.

Example 7: The device of Example 5, where the shield wall is continuous along an entire length of the signal line.

Example 8: The device of Example 5, where the at least one second shield wall portion includes a top wall extending above and along a length of the at least one second portion of the signal line; a bottom wall extending below and along the length of the at least one second portion; a first sidewall coupled to the top wall and the bottom wall and extending along a first side of the at least one second portion; and a second sidewall coupled to the top wall and the bottom wall and extending along a second side of the at least one second portion.

Example 9: The device of any of the Examples 1-8, where the contact pad is formed on a printed circuit board (PCB) substrate; the second contact pad is formed on a circuit die; and the coaxial wire trace forms the true coaxial connection between the PCB substrate and the circuit die.

Example 10: The device of any of the Examples 1-9, where: the contact pad is formed on a first circuit die; the second contact pad is formed on a second circuit die; and the coaxial wire trace forms the true coaxial connection between the first circuit die and the second circuit die.

Example 11: The device of any of the Examples 1-10, further including the antenna element formed on one of the one or more layers of the package routing; where the contact pad is formed on a circuit die; and the coaxial wire trace forms the true coaxial connection between the circuit die and the antenna element.

Example 12: The device of Example 11, where the signal line is configured to carry radio frequency signals at sub TeraHertz frequencies; and the circuit die comprises an analog beam former circuit.

Example 13: The device of any of the Examples 1-12, further including a second shield wall extending through the one or more layers of the package routing formed around an antenna cavity that includes the antenna element and, the second shield wall coupled to a reference voltage.

Example 14: The device of Example 13, further including a third shield wall formed around a periphery of the device and extending from a package ground contact pad on the PCB substrate through the one or more layers of the package routing.

Example 15: A device includes a substrate including a first circuit die and one or more second circuit dies; one or more layers of package routing on the substrate and over the first circuit die and the one or more second circuit dies; a plurality of first antenna elements formed on a first selected layer of the one or more layers of the package routing, each first antenna element formed over one of the one or more second circuit dies; and at least one coaxial trace. Each coaxial trace includes a signal line including one or more vias extending through the one or more layers of the package routing, the signal line including at least one first portion extending perpendicular to a surface of the substrate; and a shield wall coupled to a package ground and defining a ground plane extending around the signal line through the one or more layers and extending around the at least one first portion; and where the at least one coaxial trace includes one or more of a first coaxial trace between the substrate and the first circuit die, a second coaxial trace between the first circuit die and a selected second circuit die of the one or more second circuit dies, and a third coaxial trace between the selected second circuit die and selected first antenna element of the plurality of first antenna elements.

Example 16: The device of Example 15, further includes a plurality of second antenna elements formed on a second selected layer of the one or more layers of the package routing, each second antenna element formed over one of the first antenna elements of the plurality of first antenna elements; and a plurality of second shield walls, each second shield wall formed around an antenna cavity including an antenna pair including a first antenna element of the plurality of first antenna elements and a second antenna element of the plurality of second antenna elements, the second shield wall configured to isolate the antenna pair from radio frequency signals from other antenna pairs.

Example 17: The device of any of the Examples 15 or 16, where the first coaxial trace includes a first signal line extending through at least some of the one or more layers of the package routing to couple a contact pad of the substrate to a contact pad of the first circuit die; a first shield wall surrounding the first signal line along its entire length to form a true coaxial connection between the substrate and the first circuit die.

Example 18: The device of any of the Examples 15 -17, where the second coaxial trace includes a second signal line extending through at least some of the one or more layers of the package routing to couple a contact pad of the circuit die to a contact pad of the selected second die; and a second shield wall surrounding the second signal line along its entire length to form a true coaxial connection between the first circuit die and the selected second circuit die.

Example 19: The device of any of the Examples 15 or 18, where the third coaxial trace includes a third signal line extending through at least some of the one or more layers of the package routing to couple a contact pad of the selected second circuit die to the selected first antenna element of the plurality of first antenna elements; and a third shield wall surrounding the third signal line along its entire length to form a true coaxial connection between the selected second circuit die and the selected first antenna element.

Example 20: The device of any of the Examples 15-19, further includes a circuit shield wall along a periphery of the substrate and extending from a package ground connection through the one or more layers of the package routing to isolate the device from radio frequency signals from other devices.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A device comprising:
a substrate including one or more layers of package routing;
a coaxial wire trace including:
a signal line including one or more vias extending through the one or more layers of the package routing, the signal line including at least one first portion extending perpendicular to a surface of the substrate; and
a shield wall coupled to a package ground and defining a ground plane extending around the signal line and extending continuously around the signal line through the one or more layers and extending around the at least one first portion; and
wherein the shield wall and the signal line form a true coaxial connection between a contact pad and one of a second contact pad and an antenna element.

2. The device of claim 1, wherein one or more of a thickness or a composition of the one or more layers is different from others of the one or more layers.

3. The device of claim 1 or claim 2, wherein the shield wall includes at least one first shield wall portion that corresponds to the at least one first portion of the signal line.

4. The device of claim 3, wherein at least one first shield wall portion is conformal to the at least one first portion of the signal line.

5. The device of claim 3, wherein:
the signal line includes at least one second portion extending parallel to the surface of the substrate at a selected layer within the one or more layers of the package routing; and
the shield wall includes at least one second shield wall portion that corresponds to the at least one second portion of the signal line.

6. The device of claim 5, wherein the shield wall includes conductive pillars configured to provide radio frequency isolation from adjacent signal lines and from external radio frequency signals.

7. The device of claim 5, wherein the shield wall is continuous along an entire length of the signal line.

8. The device of claim 5, wherein the at least one second shield wall portion comprises:
a top wall extending above and along a length of the at least one second portion of the signal line;
a bottom wall extending below and along the length of the at least one second portion;
a first sidewall coupled to the top wall and the bottom wall and extending along a first side of the at least one second portion; and
a second sidewall coupled to the top wall and the bottom wall and extending along a second side of the at least one second portion.

9. The device of claim 1, wherein:
the contact pad is formed on a printed circuit board (PCB) substrate;
the second contact pad is formed on a circuit die; and
the coaxial wire trace forms the true coaxial connection between the PCB substrate and the circuit die.

10. The device of claim 1, wherein:
the contact pad is formed on a first circuit die;
the second contact pad is formed on a second circuit die; and
the coaxial wire trace forms the true coaxial connection between the first circuit die and the second circuit die.

11. The device according to any preceding claim, further comprising:
the antenna element formed on one of the one or more layers of the package routing;
wherein:
the contact pad is formed on a circuit die; and
the coaxial wire trace forms the true coaxial connection between the circuit die and the antenna element.

12. The device of claim 11, wherein:
the signal line is configured to carry radio frequency signals at sub TeraHertz frequencies; and
the circuit die comprises an analog beam former circuit.

13. The device according to any preceding claim, further comprising a second shield wall extending through the one or more layers of the package routing formed around an antenna cavity that includes the antenna element and, the second shield wall coupled to a ground connection associated with one of the circuit die and the substrate.

14. The device of claim 13, further comprising a third shield wall formed around a periphery of the circuit device and extending from a package ground contact pad on the PCB substrate through the one or more layers of the package routing.
